# EUROPÄISCHE PATENTANMELDUNG

(11) **EP 1 870 938 A1**
(43) Veröffentlichungstag der Anmeldung: **26.12.2007**
(21) Anmeldenummer: 07012039.9
(22) Anmeldetag: 20.06.2007
(51) Int. Cl.: H01L 29/08, H01L 27/02, H01L 29/78, H01L 29/10

(54) **Halbleiterschutzstruktur für eine elektrostatische Entladung**

(30) Priorität: 20.06.2006 DE 102006028721
(71) Anmelder: ATMEL Germany GmbH, 74072 Heilbronn (DE)
(72) Erfinder: Schwantes, Stefan, Dr., 74080 Heilbronn (DE); Grombach, Peter, 74074 Heilbronn (DE); Heid, André, 71672 Marbach (DE); Klaussner, Manfred, 74080 Heilbronn (DE)
(74) Vertreter: Müller, Wolf-Christian

(57) **Zusammenfassung**

Halbleiterschutzstruktur geeignet für eine elektrostatische Entladung (ESD) mit einem Feldeffekttransistor,
- dessen Source einen Emitter,
- dessen Body eine Basis und
- dessen Drain einen Kollektor eines Bipolartransistors bildet, bei der
- innerhalb eines Bodygebietes des Feldeffekttransistors eine Mehrzahl von Draingebieten ausgebildet ist, und
- die Draingebiete über einen Leiter miteinander verbunden sind.

## Beschreibung

Die vorliegende Erfindung betrifft eine Halbleiterschutzstruktur, die für eine elektrostatische Entladung (ESD) geeignet ist.

Aus der US 6,873,505 B2 ist ein Halbleiterbauelement bekannt, dass einen Schutzschaltkreis für elektrostatische Entladungen aufweist, der mit einer gemeinsamen Entladungsleitung (CDL) verbunden ist. In einem Ausführungsbeispiel der US 6,873,505 B2 umfasst das Halbleiterbauelement eine Vielzahl von Bondpads, denen jeweils ein Schutzschaltkreis zugeordnet ist. Zum Schutz ist ein gesteuerter Halbleitergleichrichter (SCR) aus einem pnp-Bipolartransistor und einem npn-Bipolartransistor, dessen Auslösespannung durch eine Zenerdiode als Auslöseelement reduziert ist. Typisch für ESD-Schutzschaltungen ist der so genannt snap-back-Effekt. Dabei steigt ausgehend vom Nullpunkt die Spannung zunächst signifikant an. Werden ausreichend Ladungsträger generiert sinkt die Spannung trotz weiter steigendem Strom durch die Schutzschaltung.

Der Erfindung liegt die Aufgabe zu Grunde eine Halbleiterschutzstruktur für eine elektrostatische Entladung insbesondere hinsichtlich einer Reduktion der snap-back-Spannung weiter zu entwickeln.

Diese Aufgabe wird durch die Halbleiterschutzstruktur mit den Merkmalen des unabhängigen Anspruchs gelöst. Vorteilhafte Weiterbildungen sind Gegenstand von abhängigen Ansprüchen.

Demzufolge ist eine Halbleiterschutzstruktur vorgesehen, die für eine elektrostatische Entladung geeignet ist. Die Halbleiterschutzstruktur weist einen Feldeffekttransistor auf. Halbleitergebiete des Feldeffekttransistors bilden zugleich Halbleitergebiete eines parasitären Bipolartransistors. Die Source des Feldeffekttransistors bildet einen Emitter des Bipolartransistors. Der Body des Feldeffekttransistors bildet eine Basis des Bipolartransistors. Die Drain des Feldeffekttransistors bildet einen Kollektor des Bipolartransistors. Der Body ist hierzu bevorzugt als Wanne ausgebildet, wobei in der Wanne die Source und die Drain beispielsweise durch eingebrachte, insbesondere implantierte, Dotanden ausgebildet sind.

Innerhalb eines Bodygebietes jeweils eines einzigen Feldeffekttransistors ist eine Mehrzahl von Draingebieten ausgebildet. Eine Mehrzahl von Draingebieten sind dabei zwei oder mehr als zwei Draingebiete. Diese Draingebiete sind dabei mit Dotierstoffen des gleichen Leitungstyps ausgebildet. Beispielsweise ist das Bodygebiet p-dotiert und die Draingebiete sind durch eine n+ Dotierung gebildet. Die Draingebiete sind über einen Leiter miteinander verbunden. Dieser Leiter kann beispielsweise eine Metallisierung, ein Silizid oder eine insbesondere hochdotierte Verbindung aus polykristallinem Silizium aufweisen. Jedes Draingebiet weist zum Bodygebiet einen separaten PN-Übergang auf, wobei sich entlang dieses PN-Übergangs eine Raumladungszone (RLZ) ausbildet.

Gemäß einer bevorzugten Weiterbildung ist vorgesehen, dass ein erstes Draingebiet und ein zweites Draingebiet der Mehrzahl der Draingebiete in Richtung einer Gatelänge des Feldeffekttransistors voneinander beabstandet sind. Demzufolge ist das erste Draingebiet näher als das zweite Draingebiet zur Gateelektrode angeordnet. Vorteilhafterweise ist zudem ein drittes Draingebiet und ggf. ein viertes Draingebiet der Mehrzahl der Draingebiete vorgesehen, die ebenfalls in Richtung der Gatelänge des Feldeffekttransistors voneinander und zu dem ersten Draingebiet und dem zweiten Draingebiet beabstandet ausgebildet sind.

Gemäß einer vorteilhaften Ausgestaltung der Erfindung ist vorgesehen, dass das erste Draingebiet zwischen einer Gateelektrode und dem zweiten Draingebiet ausgebildet ist. Vorteilhafterweise ist ein leitender Übergangsbereich zwischen dem Leiter und dem ersten Draingebiet näher zum zweiten Draingebiet als zur Gateelektrode ausgebildet. Hierdurch wird erreicht, dass das erste Draingebiet selbst als kleiner Widerstand ausgebildet ist, der eine gleichmäßige Stromverteilung bewirkt. Dabei kann das erste Draingebiet eine an den Widerstand angepasste Dotierstoffverteilung aufweisen.

Eine andere, auch kombinierbare Weiterbildung sieht vor, dass zumindest zwei Draingebiete der Mehrzahl der Draingebiete in Richtung einer Gateweite des Feldeffekttransistors voneinander beabstandet sind. Auch diese zwei Draingebiete sind über den Leiter miteinander leitend verbunden, insbesondere kurzgeschlossen. Die Richtung der Gateweite ist meist senkrecht zur Richtung der Gatelänge.

Die Erfindung vorteilhaft weiterbildend ist vorgesehen, dass die Mehrzahl der Draingebiete in einem Raster innerhalb des Bodygebietes ausgebildet ist. Das Raster ist bevorzugt zweidimensional, so dass eine Matrix aus Spalten und Zeilen von Draingebieten gebildet ist. Auch ist ein dreidimensionales Raster möglich. Auch ist es möglich mehrere Draingebiete in verschiedenen Schichttiefen im Halbleitermaterial der Halbleiterschutzstruktur auszubilden.

Gemäß einer anderen vorteilhaften Weiterbildung der Erfindung ist vorgesehen, dass der Feldeffekttransistor als geschlossene Struktur ausgebildet ist. Für einen NMOS-Feldeffekttransistor sind bevorzugt ein Bodyanschlussgebiet des Bodys im äußeren Bereich der geschlossenen Struktur und die Draingebiete im inneren Bereich der geschlossenen Struktur ausgebildet. Gemäß einer vorteilhaften Ausgestaltung ist vorgesehen, dass ein pn-Übergang zwischen Body und Source die geschlossene Struktur vollständig umläuft.

In vorteilhaften Ausgestaltungen dieser Weiterbildung ist die geschlossene Struktur ringförmig oder oval. Diese Strukturen ermöglichen den für elektrostatische Entladungen kritischen Anschluss, beispielsweise im Falle eines NMOS-Feldeffekttransistors bzw. parasitären npn-Bipolartransistors den Kathodenanschluss der Halbleiterschutzstruktur, in den Innenbereich der Halbleiterschutzstruktur und den Anodenanschluss im Außenbereich der Halbleiterschutzstruktur anzuordnen. Weiterhin werden durch die geschlossene Struktur Randeffekte an Grenzflächen insbesondere zu Dielektrika reduziert oder sogar vollständig verhindert.

Bevorzugt ist eine Gateelektrode des Feldeffekttransistors auf ein festes Potential derart gelegt, dass sich unterhalb der Gateelektrode kein Leitungskanal ausbildet. In diesem Fall sperrt der Feldeffekttransistor. Zum Anlegen eines festen Potentials an der Gateelektrode gibt es verschiedene Möglichkeiten. Gemäß einer bevorzugten Ausgestaltung der Erfindung ist eine Gateelektrode des Feldeffekttransistors leitend mit der Source und/oder dem Body verbunden. Beispielsweise sind ein Bodyanschlussgebiet, ein Sourcegebiet und die Gateelektrode über eine Metallisierung kurzgeschlossen (ggMOS).

Um einen so genannten Latch-up Effekt zu verhindern ist in einer vorteilhaften Ausgestaltung vorgesehen, dass der Feldeffekttransistor durch ein vergrabenes Dielektrikum in vertikaler Richtung und durch eine mit Dielektrikum verfüllte Grabenstruktur in lateraler Richtung isoliert ist. (Box) Diese Isolationsstrukturen dienen der Isolation gegenüber einem Substrat und/oder gegenüber einer benachbarten Halbleiterstruktur, wie beispielsweise einem Feldeffekttransistor.

Im Folgenden wird die Erfindung durch Ausführungsbeispiele anhand zeichnerischer Darstellungen näher erläutert.

### Es zeigen

- Fig. 1: eine schematische Schnittansicht eines Teils einer Halbleiterschutzstruktur, die für eine elektrostatische Entladung geeignet ist,
- Fig. 2: eine schematische Draufsicht auf einen Teil einer Halbleiterschutzstruktur eines ersten Ausführungsbeispiels,
- Fig. 3: eine schematische Draufsicht auf einen Teil einer Halbleiterschutzstruktur eines zweiten Ausführungsbeispiels,
- Fig. 4: eine schematische Draufsicht auf einen Teil einer Halbleiterschutzstruktur eines dritten Ausführungsbeispiel, und
- Fig. 5a und 5b: schematische Draufsichten auf Kombinationen mehrerer Teile einer geschlossenen Halbleiterschutzstruktur.

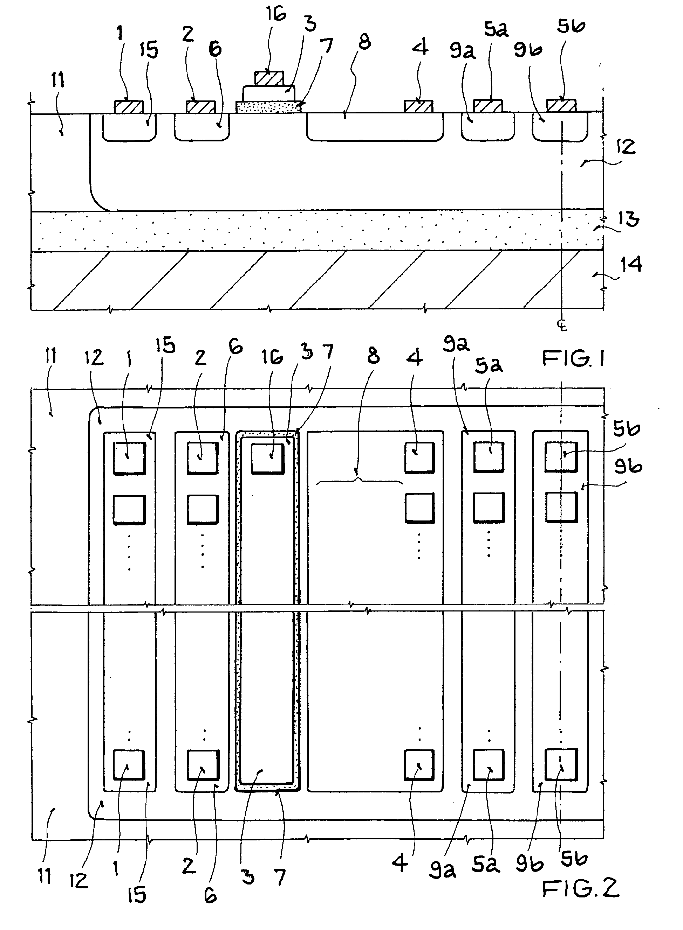

Eine schematische Schnittansicht durch eine Halbleiterplättchen mit einer Halbleiterschutzstruktur zeigt die Fig. 1. Diese ist für elektrostatische Entladungen geeignet und wird auch als ESD-Struktur (engl. electro-staticdischarge) bezeichnet. Diese Halbleiterschutzstruktur ist mit Anschlüssen einer integrierten Schaltung verbunden, die gegen elektrostatische Entladungen durch die Halbleiterschutzstruktur geschützt werden soll. Über Anschlüsse der integrierten Schaltung können elektrostatische Entladungen einwirken. Zum Schutz ist die Halbleiterschutzstruktur ebenfalls mit diesen Anschlüssen verbunden. Vorteilhafterweise ist die Halbleiterschutzstruktur mit der zu schützenden integrierten Schaltung auf einem Halbleiterplättchen gemeinsam integriert und in demselben Herstellungsprozess hergestellt.

Die Halbleiterschutzstruktur weist einen Feldeffekttransistor mit einer Source, einer Drain, einem Gate und einem Body auf. Der Body kann auch als Bulk bezeichnet werden. In Fig. 1 ist ein Bodygebiet 12 dargestellt, das im Ausführungsbeispiel eines NMOS-Feldeffekttransistors p-dotiert ist. Ein höher p-dotiertes Bodyanschlussgebiet 15 ist mittels einer Body-Metallisierung 1 angeschlossen. Auf einem Teilgebiet des Bodygebietes 12 ist ein Gateoxid 7 mit einer Gateelektrode 3 angeordnet. Die Gateelektrode 3 ist mittels einer Gate-Metallisierung 16 angeschlossen.

Der Feldeffekttransistor der Fig. 1 wird als ESD-Struktur ausschließlich im gesperrten Zustand betrieben. Hierzu ist wird die Gateelektrode auf ein Potential gelegt, dass die Ausbildung eines Kanals im Teilgebiet unterhalb des Gateoxids 7 verhindert. Hierzu sind die Gate-Metallisierung und die Body-Metallisierung beispielsweise kurzgeschlossen (in Fig. 1 nicht dargestellt). Weiterhin ist zwischen dem Bodyanschlussgebiet 15 und dem Gateoxid 7 im Bodygebiet 12 ein Sourcegebiet 6, beispielsweise durch Implantation eines n-leitenden Dotierstoffes ausgebildet. Das Sourcegebiet 6 ist ebenfalls durch eine Metallisierung (in Fig. 1 nicht dargestellt) mit dem Bodyanschlussgebiet 15 und der Gateelektrode 16 kurzgeschlossen.

Weiterhin sind in der Schnittdarstellung des Ausführungsbeispiels der Fig. 1 ein erstes Draingebiet 8, ein zweites Draingebiet 9a und ein drittes Draingebiet 9b durch Implantation eines n-leitenden Dotierstoffes ausgebildet. Alle Draingebiete sind also n-leitend. Das erste Draingebiet 8 ist durch eine erste Drain-Metallisierung 4, das zweite Draingebiet 9a ist durch eine zweite Drain-Metallisierung 5a und das dritte Draingebiet 9b ist durch eine dritte Drain-Metallisierung 5b angeschlossen. Alle Draingebiete 8, 9a, 9b sind durch einen als Metallisierung ausgebildeten Metallleiter (in Fig. 1 nicht dargestellt) kurzgeschlossen. Sie liegen daher auf demselben Potential.

Im Fall einer elektrostatischen Entladung wird eine Spannung zwischen den Drainanschlüssen 4, 5a und 5b und dem Bodyanschluss 1 generiert. Diese Spannung bewirkt ein elektrisches Feld in einer Raumladungszone entlang jedes durch das jeweilige Draingebiet 8, 9a, 9b und dem Bodygebiet 12 gebildeten PN-Übergangs. Jedes Draingebiet 8, 9a, 9b bildet mit dem Bodygebiet 12 folglich eine eigene Drain-Body-Diode aus. Die Feldstärke ist in einem Bereich der Raumladungszone des jeweiligen Draingebietes 8, 9a, 9b am größten, dass dem Bodyanschlussgebiet 15 zugewandt ist. Aufgrund der größten Feldstärke in diesem Bereich, wird in diesem Bereich auch die größte Anzahl von Ladungsträgern generiert. Die drei Draingebiete 8, 9a, 9b weisen jeweils einen solchen Bereich auf, so dass die Ladungsträgergeneration in Summe durch diese drei Draingebiete 8, 9a, 9b höher ist als bei einem einzigen Draingebiet.

Je größer die Ladungsträgergeneration, desto größer ist der Strom, der in das Bodyanschlussgebiet 15 fließt. Diese Strom erzeugt einen Spannungsabfall im Bodygebiet 12 und Bodyanschlussgebiet 15, so dass der PN-Übergang zwischen Bodygebiet 12 und Sourcegebiet 6 in Flussrichtung betrieben wird (> 0,7 V). Hierdurch schaltet der Bipolartransistor aufgrund der positiven Basis-Emitter-Spannung auf. Die Ladung kann durch die Kollektor-Emitter-Strecke des aufgeschalteten Bipolartransistors entladen werden. Hierdurch kann also die so genannte Snap-Back-Spannung deutlich reduziert werden.

Das erste Draingebiet 8 weist eine in Richtung einer Gatelänge sich erstreckende Länge auf. Der erste Drainanschluss 4 ist dabei von der Gateelektrode 16 entfernt auf dem ersten Draingebiet 8 angeordnet. Dies bewirkt, dass das Draingebiet 8 für den Stromfluss in Richtung des Bodyanschlussgebietes 15 als kleiner Widerstand wirkt. Der kleine Widerstand wiederum bewirkt eine gleichmäßige Verteilung des durch die Generation der Ladungsträger erzeugten Stromes. Lokale Stromüberhöhungen werden dadurch reduziert oder ganz vermieden.

Ein Dielektrikum 13 isoliert das Bodygebiet 12 des Feldeffekttransistors von einem Halbleitersubstrat 14, so dass eine so genannte SOI-Struktur (semiconductor on insulator) ausgebildet ist. Weiterhin wird die Halbleiterschutzstruktur durch eine isolierende mit Dielektrikum verfüllte Grabenstruktur 11 gegenüber einer oder mehreren benachbarten Halbleiterstrukturen isoliert. Zudem können die, an die Oberfläche grenzenden Halbleiterbereiche 12, 15, 6, 8, 9a, 9b durch eine Schicht aus Bor-Phosphor-Silikat-Glas (BPSG) zur Isolierung bedeckt sein.

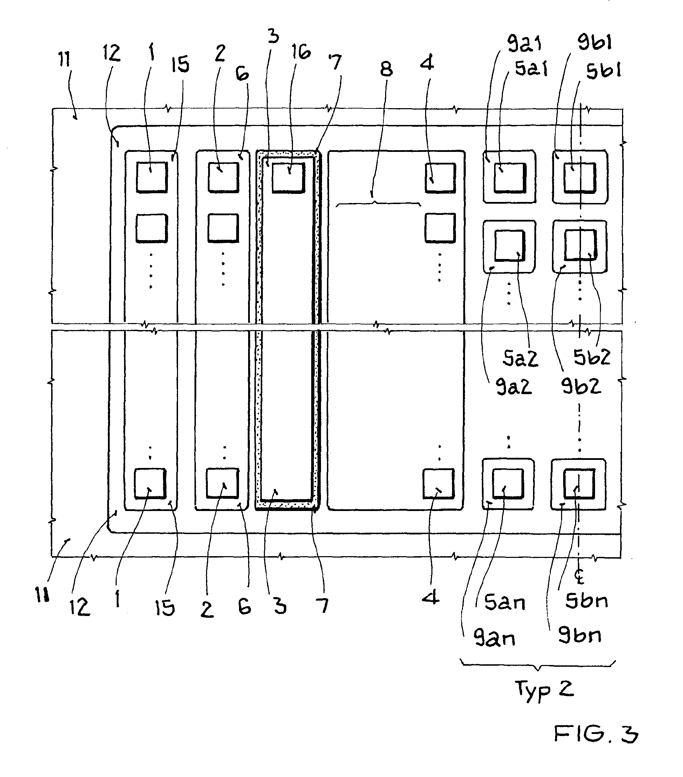

Fig. 2 zeigt eine schematische Draufsicht auf einen Teil einer Halbleiterschutzstruktur eines zur Fig. 1 korrespondierenden Ausführungsbeispiels. Das Bodyanschlussgebiet 15, das Sourcegebiet 6, Die GateElektrode 3 und die Draingebiete 8, 9a und 9b erstrecken sich ununterbrochen in Längsrichtung länglich in Richtung einer Gate-Weite. Entlang dieser länglichen Erstreckung weist jedes Gebiet 15, 6, 8, 9a, 9b und die Gateelektrode 3 jeweils eine Vielzahl von metallischen Anschlüssen 1, 2, 16, 4, 5a, 5b auf. Dabei sind alle metallischen Anschlüsse 1, 2, 16 des Bodys, der Source und der Gateelektrode kurzgeschlossen (in Fig. 2 nicht dargestellt). Ebenfalls sind alle metallischen Anschlüsse 4, 5a, 5b der Draingebiete 8, 9a, 9b durch einen metallischen Leiter kurzgeschlossen (in Fig. 2 ebenfalls nicht dargestellt). Die mit Dielektrikum gefüllte Grabenstruktur 11 umschließt den Feldeffekttransistor der Halbleiterschutzstruktur vollständig.

Fig. 3 zeigt ein zu Fig. 2 alternatives Ausführungsbeispiel, das in einer Halbleiterschutzstruktur auch mit dem Ausführungsbeispiel der Fig. 2 kombiniert werden kann. Das Draingebiet 8 ist unverändert. Hingegen sind nun eine Mehrzahl weiterer Draingebiete 9a1 bis 9an und 9b1 bis 9bn vorgesehen. Diese Draingebiete 9a1 bis 9an und 9b1 bis 9bn sind dabei im Raster angeordnet. Dabei bildet das Raster eine Matrix mit zwei Spalten und n Zeilen. Draingebiete 9a1 bis 9an und 9b1 bis 9bn sind dabei in Richtung einer Länge der Gateelektrode 3 voneinander beabstandet. Auch sind Draingebiete 9a1 bis 9an und 9b1 bis 9bn in Richtung einer Weite der Gateelektrode 3 voneinander beabstandet. Jedes dieser Draingebiete 9a1 bis 9an und 9b1 bis 9bn ist von einem anderen dieser Draingebiete 9a1 bis 9an und 9b1 bis 9bn durch einen Teil des Bodygebietes 12 getrennt. Alle Draingebiete 9a1 bis 9an und 9b1 bis 9bn sind durch einen Metallleiter miteinander kurzgeschlossen.

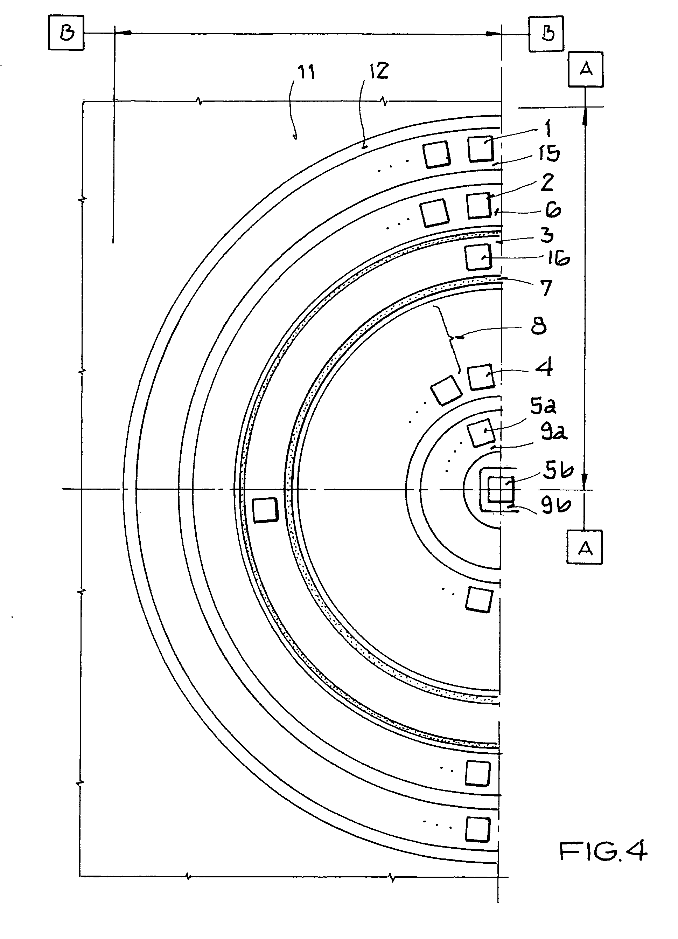

Fig. 4 zeigt ein weiteres, auch kombinierbares Ausführungsbeispiel einer Halbleiterschutzstruktur in schematischer Draufsicht. Dargestellt ist ein Teil einer Halbleiterschutzstruktur als Halbkreis mit zwei Viertelkreissegmenten A - A, B - B. Im Kreismittelpunkt sind in diesem Ausführungsbeispiel die Draingebiete 8, 9a, 9b ausgebildet. Diese sind in Reihenfolge von der Gateelektrode 3, dem Sourcegebiet 6, dem Bodyanschlussgebiet 15 und der Grabenstruktur 11 umgeben. Alternativ kann natürlich auch ein Raster von Draingebieten analog der Fig. 3 im inneren der Halbkreisstruktur ausgebildet werden.

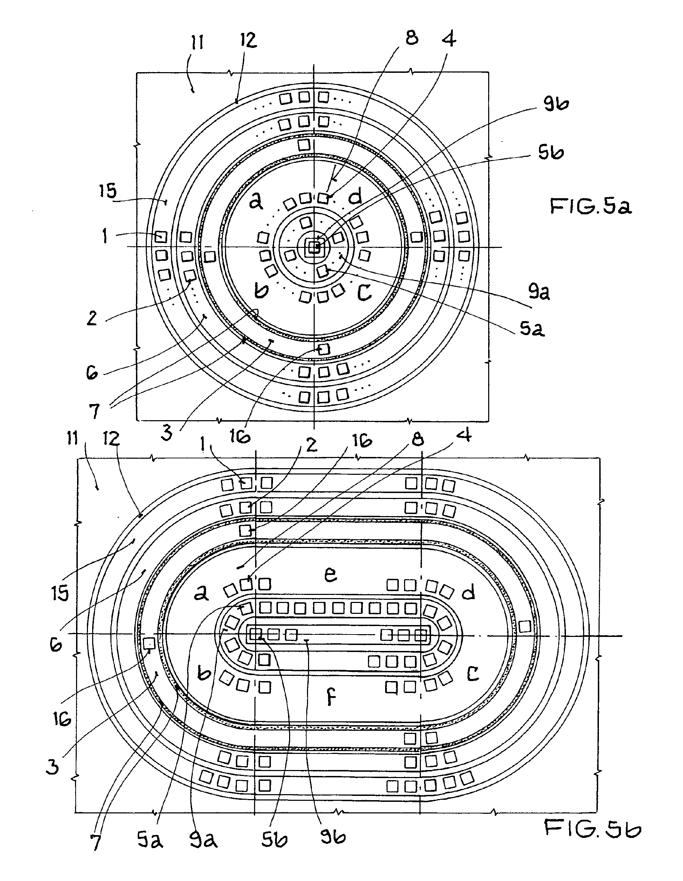

Die Figuren 5a und 5b zeigen zwei Ausführungsbeispiele für eine vollständige Halbleiterschutzstruktur in Draufsicht, die sich aus Teilansichten der zuvor beschriebenen Ausführungsbeispiele zusammensetzt. Fig. 5a zeigt eine geschlossene Struktur als Kreisstruktur. Jedes Viertelkreissegment a, b, c bzw. d entspricht dabei einem Viertelkreissegment der Fig. 4.

Fig. 5b zeigt eine geschlossene Struktur als Oval (Stadionstruktur). Dabei entsprechen die Viertelkreissegmente a, b, c und d einem Viertelkreissegment der Fig. 4. Die Segmente e und f entsprechen dabei einer Länglichen Erstreckung der Struktur analog der Fig. 2 oder der Fig. 3. Dabei sind die Draingebiete 8, 9a, 9b in der Mitte der Ovalstruktur ausgebildet.

Die Figuren 5a und 5b weisen den Vorteil auf, dass keine Randgebiete vorhanden sind, in denen Grenzflächen, beispielsweise ein weiterer PN-Übergang, die Funktionsweise des Bauelementes beeinträchtigen könnten. Zudem sind diese Strukturen Platz sparend zu integrieren.

Die Erfindung ist nicht auf die dargestellten Ausführungsbeispiele beschränkt. Eine alternative Ausgestaltung sieht beispielsweise einen PMOS-Feldeffekttransistor mit einem durch den PMOS-Feldeffekttransistor gebildeten parasitären pnp-Bipolartransistor vor. Auch die geometrische Ausbildung der Draingebiete kann von den in den Figuren dargestellten abweichen.

## Patentansprüche

1. Halbleiterschutzstruktur geeignet für eine elektrostatische Entladung (ESD) mit einem Feldeffekttransistor,
- dessen Source einen Emitter,
- dessen Body eine Basis und
- dessen Drain einen Kollektor
eines Bipolartransistors bildet, bei der
- innerhalb eines Bodygebietes (12) des Feldeffekttransistors eine Mehrzahl von Draingebieten (8, 9a, 9b, 9a1 bis 9an, 9b1 bis 9bn) (gleicher Leitungstyp) ausgebildet ist, und
- die Draingebiete (8, 9a, 9b, 9a1 bis 9an, 9b1 bis 9bn) über einen Leiter miteinander verbunden sind .

2. Halbleiterschutzstruktur geeignet für eine elektrostatische Entladung (ESD) nach Anspruch 1, bei der
ein erstes Draingebiet (8) und ein zweites Draingebiet (9a, 9b, 9a1 bis 9an, 9b1 bis 9bn) der Mehrzahl der Draingebiete (8, 9a, 9b, 9a1 bis 9an, 9b1 bis 9bn) in Richtung einer Gatelänge des Feldeffekttransistors voneinander beabstandet sind.

3. Halbleiterschutzstruktur geeignet für eine elektrostatische Entladung (ESD) nach Anspruch 2, bei der
das erste Draingebiet (8) zwischen einer Gateelektrode (3) und dem zweiten Draingebiet (9a, 9b, 9a1 bis 9an, 9b1 bis 9bn) ausgebildet ist, und
ein leitender Übergangsbereich zwischen dem Leiter und dem ersten Draingebiet (8) näher zum zweiten Draingebiet (9a, 9b, 9a1 bis 9an, 9b1 bis 9bn) als zur Gateelektrode (3) ausgebildet ist.

4. Halbleiterschutzstruktur geeignet für eine elektrostatische Entladung (ESD) nach einem der vorhergehenden Ansprüche, bei der
zwei Draingebiete (9a1 und 9a2) der Mehrzahl der Draingebiete (8, 9a, 9b, 9a1 bis 9an, 9b1 bis 9bn) in Richtung einer Gateweite des Feldeffekttransistors voneinander beabstandet sind.

5. Halbleiterschutzstruktur geeignet für eine elektrostatische Entladung (ESD) nach einem der vorhergehenden Ansprüche, bei der
die Mehrzahl der Draingebiete (8, 9a, 9b, 9a1 bis 9an, 9b1 bis 9bn) in einem Raster innerhalb des Bodygebietes (12) ausgebildet ist.

6. Halbleiterschutzstruktur geeignet für eine elektrostatische Entladung (ESD) nach einem der vorhergehenden Ansprüche, bei der
der Feldeffekttransistor als geschlossene Struktur ausgebildet ist, wobei ein Bodyanschlussgebiet (15) des Bodys im äußeren Bereich der geschlossenen Struktur und die Draingebiete (8, 9a, 9b, 9a1 bis 9an, 9b1 bis 9bn) im inneren Bereich der geschlossenen Struktur ausgebildet sind.

7. Halbleiterschutzstruktur geeignet für eine elektrostatische Entladung (ESD) nach Anspruch 6, bei der
die geschlossene Struktur ringförmig oder oval ist.

8. Halbleiterschutzstruktur geeignet für eine elektrostatische Entladung (ESD), nach einem der Ansprüche 6 oder 7, bei der ein PN-Übergang zwischen Bodygebiet (12) und Sourcegebiet (6) die geschlossene Struktur vollständig umläuft.

9. Halbleiterschutzstruktur geeignet für eine elektrostatische Entladung (ESD) nach einem der vorhergehenden Ansprüche, bei der
eine Gateelektrode (3) des Feldeffekttransistors auf ein festes Potential derart gelegt ist, dass sich unterhalb der Gateelektrode (3) kein Leitungskanal ausbildet.

10. Halbleiterschutzstruktur geeignet für eine elektrostatische Entladung (ESD) nach einem der vorhergehenden Ansprüche, bei der
eine Gateelektrode (3) des Feldeffekttransistors leitend mit der Source und/oder dem Body verbunden ist.

11. Halbleiterschutzstruktur geeignet für eine elektrostatische Entladung (ESD) nach einem der vorhergehenden Ansprüche, bei der
der Feldeffekttransistor durch ein vergrabenes Dielektrikum (13) in vertikaler Richtung und durch eine mit Dielektrikum verfüllte Grabenstruktur (11) in lateraler Richtung isoliert ist.
